## Europäisches Patentamt

## European Patent Office

## Office européen des brevets

(11) Veröffentlichungsnummer: **0 094 044**
**A2**

# EUROPÄISCHE PATENTANMELDUNG

(21) Anmeldenummer: **83104436.7**

(22) Anmeldetag: **05.05.83**

(51) Int. Cl.³: **H 03 K 19/092**

(30) Priorität: **10.05.82 DE 3217512**

(43) Veröffentlichungstag der Anmeldung: **16.11.83**
**Patentblatt 83/46**

(84) Benannte Vertragsstaaten: **AT DE FR GB IT**

(71) Anmelder: **SIEMENS AKTIENGESELLSCHAFT, Berlin und München Wittelsbacherplatz 2, D-8000 München 2 (DE)**

(72) Erfinder: **Lechner, Alexander, Dr. Dipl.-Ing., Dietrichsteinerstrasse 27, A-9583 Faak (AT)**

(54) **Schaltungsanordnung zur Pegelumsetzung.**

(57) Die Erfindung betrifft eine Schaltungsanordnung zur Pegelumsetzung von ECL-Logik-Pegeln zu TTL-Logik-Pegeln mit einem eingangsseitig von ECL-Logik-Pegeln beaufschlagten emittergekoppelten Stromschalter und einer TTL-Ausgangsstufe, bei der eine spannungsgesteuerte Stromquelle (B) vorgesehen ist, die eingangsseitig von einem Ausgang des Stromschalters (A) beaufschlagt ist und die ausgangsseitig mit der TTL-Ausgangsstufe (C) verbunden ist.

EP 0 094 044 A2

SIEMENS AKTIENGESELLSCHAFT                Unser Zeichen
Berlin und München                       VPA 82 P 5 3 0 2 E

Schaltungsanordnung zur Pegelumsetzung

Die Erfindung betrifft eine Schaltungsanordnung zur Pegelumsetzung von ECL-Logik-Pegeln zu TTL-Logik-Pegeln mit einem eingangsseitig von ECL-Logik-Pegeln beaufschlagten emittergekoppelten Stromschalter und einer TTL-Ausgangsstufe.

Pegelumsetzer (Converter) dienen zum Umsetzen der Logikpegel einer Schaltgliederfamilie auf die Logikpegel einer anderen Familie. Unter ECL-Pegeln werden dabei die Pegel der ECL (Emitter-Coupled-Logic) -Technik, unter TTL-Pegeln die Pegel der TTL (Transistor-Transistor-Logik) -Technik, aber im allgemeinen auch andere Standard-Logik-Pegel wie z.B. die Pegel der RTL (Widerstands-Transistor-Logik) -, DTL (Dioden-Transistor-Logik) -Technik oder HLL (High-Level-Logic) -Pegel verstanden. TTL-Pegel sind in der Regel so genormt, daß die auf das Potential "0" bezogene Spannung zur Darstellung eines logischen "High"-Zustandes $\geq$ 2 Volt und zur Darstellung eines logischen "Low"-Zustandes $\leq$ 0,3 Volt sein muß. Die ECL-Pegel sind im allgemeinen ebenfalls auf das Potential "0" bezogen, weisen aber einen deutlich geringeren Störabstand zwischen "High"-Zustand und "Low"-Zustand auf. Z.B. muß bei ECL-Pegeln die Spannung zur Darstellung eines logischen "High"-Zustandes größer gleich -0,98 Volt und zur Darstellung eines logischen "Low"-Zustandes kleiner gleich -1,63 Volt sein.

Nte 1 vi/05.05.1982

0094044

-2- VPA 82 P 5 3 0 2 E

Schaltungsanordnungen der eingangs genannten Art sind z.B. aus The Integrated Circuits Catalog for Design Engineers, First Edition, Texas Instrumentes, 1971, Seiten 4-73 bis 4-84 oder aus Motorola MECL Integrated Circuits, 1978, Seite 3-21, bekannt. Um sowohl ECLals auch TTL-Pegel auf die Spannung "0" beziehen zu können, benötigen die bekannten Schaltungsanordnungen zwei Versorgungsspannungen unterschiedlicher Polarität und somit eine aufwendigere Stromversorgung als Pegelumsetzer, die nur eine Versorgungsspannung benötigen.

Aufgabe der Erfindung ist es, hier Abhilfe zu schaffen und eine Schaltungsanordnung zur Pegelumsetzung vorzusehen, die geringe Verzögerungszeiten aufweist und nur eine einzige Versorgungsspannung benötigt.

Diese Aufgabe wird bei einer Schaltungsanordnung der eingangs genannten Art erfindungsgemäß dadurch gelöst, daß eine spannungsgesteuerte Stromquelle vorgesehen ist, die eingangsseitig von einem Ausgang des Stromschalters beaufschlagt ist und die ausgangsseitig mit der TTL-Ausgangsstufe verbunden ist. Dadurch gelingt es bei geringer Verzögerungszeit und bei nur einer Versorgungsspannung ECL-Pegel in TTL-Pegel zu wandeln.

Ausgestaltungen der erfindungsgemäßen Schaltungsanordnung sind in Unteransprüchen gekennzeichnet.

Die Erfindung wird im folgenden anhand der Figuren näher erläutert.

Es zeigen:

Die Fig. 1 ein Blockschaltbild für eine erfindungsgemäße Schaltungsanordnung,

die Fig. 2 ein Schaltbild eines Ausführungsbeispiels für eine erfindungsgemäße Schaltungsanordnung,

die Fig. 3 ein Schaltbild eines weiteren Ausführungsbeispiels einer erfindungsgemäßen Schaltungsanordnung,

die Fig. 4 eine statische Übertragungskennlinie einer erfindungsgemäßen Schaltungsanordnung und

die Fig. 5 ein das Schaltverhalten einer erfindungsgemäßen Schaltungsanordnung verdeutlichendes Impulsdiagramm.

In den Figuren sind gleiche Elemente mit gleichen Bezugszeichen bezeichnet.

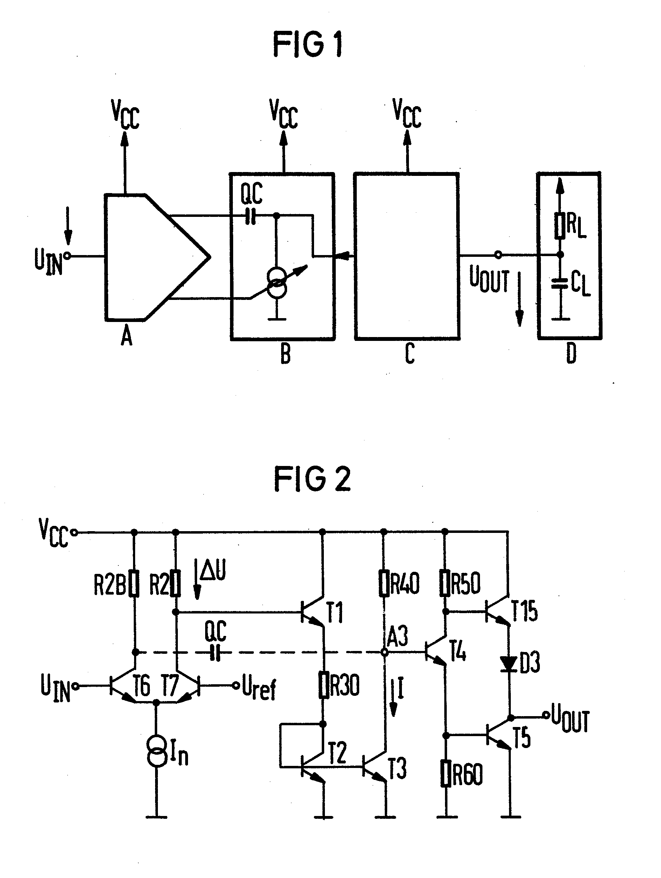

Beim in der Fig. 1 gezeigten Prinzipschaltbild eines erfindungsgemäßen Pegelwandlers beaufschlagt die einem ECL-Pegel entsprechende Eingangsspannung $U_{IN}$ einen ECL-Ausgangsdifferenzverstärker A, der einen Ausgangsspannungshub von $\Delta U$ aufweist. Der Eingangspegel $U_{IN}$ ist auf die Versorgungsspannung $V_{cc}$ bezogen. Der Differenzverstärker A beaufschlagt ein spezielles Anpassungsnetzwerk in Form einer spannungsgesteuerten Stromquelle B, die in Abhängigkeit vom an ihrem Eingang anliegenden Eingangspotential unterschiedliche Stromstärken erzeugt und ihrerseits eine TTL-Ausgangsstufe C beaufschlagt, die die unterschiedlichen Stromstärken in die gewünschten TTL-Pegel umsetzt. Die Ausgangsspannung $U_{Out}$ der TTL-Ausgangsstufe C kann dann einen Lastkreis D mit Lastwiderstand $R_L$ und Lastkapazität $C_L$ beaufschlagen.

Die Blöcke A, B und C werden mit einer für alle drei Blöcke identischen Versorgungsspannung $V_{cc}$ versorgt.

Dadurch gelingt es, das Hauptproblem für die Realisierung eines ECL-TTL-Pegelwandlers, nämlich die verschiedenen Bezugspotentiale für beide Pegel (positive Versorgung für ECL, negative Versorgung für TTL), durch ein spezielles Anpassungsnetzwerk in Form einer spannungsgesteuerten Stromquelle zu lösen.

Das Schaltverhalten wird durch eine zusätzliche dynamische Spannungseinkopplung mittels des zwischen Ausgang des Differenzverstärkers A und Stromquelle B geschalteten Kondensators QC verbessert.

Fig. 2 zeigt das Schaltbild eines Ausführungsbeispiels einer einfachen Realisierung des erfindungsgemäßen Wandlers. Der Block A der Fig. 1 ist durch einen als üblichen Stromschalter ausgeführten ECL-Ausgangsdifferenzverstärker, d.h. aus zwei emittergekoppelten npn-Transistoren T6 und T7, deren Kollektoren über die Kollektorwiderstände R2B und R2 an der Versorgungsspannung $V_{cc}$ anliegen, deren Emitter mit einer Stromquelle $I_n$, die ihrerseits an Masse liegt, verbunden sind, ausgeführt. Die Basis des Transistors T6 wird vom Eingangssignal $U_{IN}$ beaufschlagt, die Basis des Transistors T7 ist mit der Referenzspannung $U_{ref}$ verbunden, die so gewählt ist, daß sie etwa in der Mitte zwischen dem "High"- und dem "Low"-Pegel des Eingangssignals $U_{IN}$ liegt.

Entsprechende Differenzverstärker sind z.B. aus
U. Tietze und Ch. Schenk, Halbleiter-Schaltungstechnik,
5. Auflage, Springer-Verlag Berlin - Heidelberg -
New York, 1980, insbesondere Seiten 153, 154, bekannt.

Am nicht invertierenden Ausgang des aus den Transistoren T6 und T7 gebildeten Stromschalters bzw. am Widerstand R2 ist die Spannung gleich $V_{cc}$, wenn das Eingangssignal $U_{IN}$ "High" und $V_{cc} - \Delta U$, wenn das Eingangssignal $U_{IN}$ "Low" ist. $\Delta U$ wird als Ausgangsspannungshub bezeichnet. Der Widerstand R2 wird so dimensioniert, daß der Ausgangsspannungshub $\Delta U$ die gewünschte Größe, die im allgemeinen größer als der Spannungshub eines üblichen ECL-Stromschalters ist, aufweist.

Die Stromquelle B besteht aus den Transistoren T1, T2 und T3 und ist im gezeigten Beispiel somit als Stromspiegel mit Transistordiode ausgeführt. Der mit seiner Basis am nicht invertierenden Ausgang des Differenzverstärker A liegende Transistor T1 wirkt als Emitterfolger und steuert somit den Strom durch seinen Emitterwiderstand R30. Die Transistoren T2 und T3 sind als Stromspiegel mit Transistordiode geschaltet, d.h. sowohl ihre Basis- als auch ihre Emitterelektroden sind miteinander gekoppelt, beim als Transistordiode wirkenden Transistor T2 sind Basis und Kollektor kurzgeschlossen und die Basis-Emitter-Schwellspannung der Transistoren T2 und T3 ist identisch. Entsprechende Schaltungen sind z.B. aus U. Tietze und Ch. Schenk, Halbleiter-Schaltungstechnik, 5. Auflage, Springer-Verlag Berlin - Heidelberg - New York, 1980, Seiten 55 und 56 bekannt und haben zur Folge, daß die Kollektorströme I beider Transistoren identisch sind, der Strom also "gespiegelt" wird.

Die Stromquelle B ist so ausgeführt, daß bei am Eingang (Basis des Transistors T1) anliegender hoher Spannung am Ausgang A3 (Kollektor des Transistors T3) ein großer gegen Masse fließender Steuerstrom I und bei am Eingang anliegender kleiner Spannung am Ausgang A3 ein kleiner aber von Null unterschiedlicher, gegen Masse fließender Steuerstrom I, zur Verfügung steht. Dabei ist vorteilhafterweise der große Steuerstrom I mindestens zweimal, insbesondere zwei- bis viermal so groß wie der kleine Steuerstrom zu wählen.

Der Steuerstrom I steuert die TTL-Ausgangsstufe C, die als übliche TTL-Ausgangsstufe gestaltet sein kann, aus. Im Ausführungsbeispiel der Fig. 2 ist die Ausgangsstufe als Gegentaktstufe ausgeführt, so daß der Transistor T4, dessen Basis am Ausgang A3 und über den Widerstand R40 an $V_{cc}$ liegt und an dessen Kollektor der Kollektorwiderstand R50 und an dessen Emitter der Emitterwiderstand R60 angeschlossen sind, als Treibertransistor für die Transistoren T5 und T15 dient. Am Ausgang des Transistors T5, dessen Basis mit dem Emitter des Transistors T4 und dessen Emitter mit Masse verbunden ist, ist die TTL-Pegeln entsprechende Ausgangsspannung $U_{Out}$ zu entnehmen. Der Transistor T15, dessen Basis mit dem Kollektor des Transistors T4 und dessen Kollektor mit der Versorgungsspannung $V_{cc}$ verbunden ist, und die Diode D3, die zwischen Emitter des Transistors T15 und dem Kollektor des Transistors T5 geschaltet ist, wirken als sogenannter "Pullup" d.h. zum Hochziehen der Ausgangsspannung $U_{Out}$ in Richtung der Versorgungsspannung $V_{cc}$.

Ist die an der Basis des Transistors T4 anliegende Spannung größer als zwei Emitter-Basis-Schwellspannungen, so leiten die Transistoren T4 und T5, die Ausgangsspannung $U_{Out}$ ist also klein ("Low"-Pegel). Ist die Basisspannung des Transistors T4 kleiner als zwei Basis-Emitter-Schwellspannungen, so sperrt der Transistor T5, am Ausgang $U_{Out}$ liegt ein "High"-Pegel.

Der Widerstand R40 ist dabei vorteilhafterweise so zu dimensionionieren, daß bei minimalem Steuerstrom $I_{Hmin}$ für ein "High"-Ausgangssignal (unter Berücksichtigung aller Streuungen) die Gleichung

$$V_{cc, max} - R_{40} \cdot I_{Hmin} < 2 \cdot U_{be}$$

mit $V_{cc, max}$ = maximale Versorgungsspannung,

$U_{be}$ = Basis-Emitter-Schwellspannung, erfüllt ist und bei maximalem Steuerstrom $I_{Lmax}$ für ein "Low"-Ausgangssignal (unter Berücksichtigung aller Streuungen) die Gleichung

$$V_{cc, min} - R_{40} \cdot I_{Lmax} > 2 \, U_{be},$$

mit $V_{cc, min}$ = minimaler Versorgungsspannung, erfüllt ist.

Auf diese Weise gelingt es, einen ECL-TTL-Pegelwandler der insbesondere für einen integrierten Schaltkreis, der intern in ECL-Schaltungstechnik aufgebaut ist, außen TTL-kompatible Anschlüsse aufweist und ausschließlich mit einer Versorgungsspannung (beispielsweise + 5 Volt) betrieben wird, vorzusehen. Durch die Verwendung einer Stromkopplung (Stromquelle B) anstelle einer Spannungskopplung gelingt es auch bei schwankender Versorgungsspannung $V_{cc}$ Schmutzeffekte bei der Pegelumsetzung zu vermeiden und somit stabile Ausgangspegel zu gewährleisten.

Da eine Stromsteuerung aber geringfügig langsamer als eine Spannungssteuerung arbeitet, empfiehlt es sich zur Beschleunigung der Stromsteuerung eine dynamische Kopplung mittels der Koppelkapazität QC, die zwischen dem invertierenden Ausgang des Stromschalters A und dem Steuereingang A3 der TTL-Ausgangsstufe C geschaltet ist, vorzusehen. Diese Kapazität kann als Sperrschichtkapazität einer Diode oder als Oxydkapazität realisiert werden. Die Koppelkapazität C führt durch dynamische Beschleunigung, d.h. durch eine Spannungskopplung im Schaltmoment, zu steilen Flanken und geringen Verzögerungszeiten.

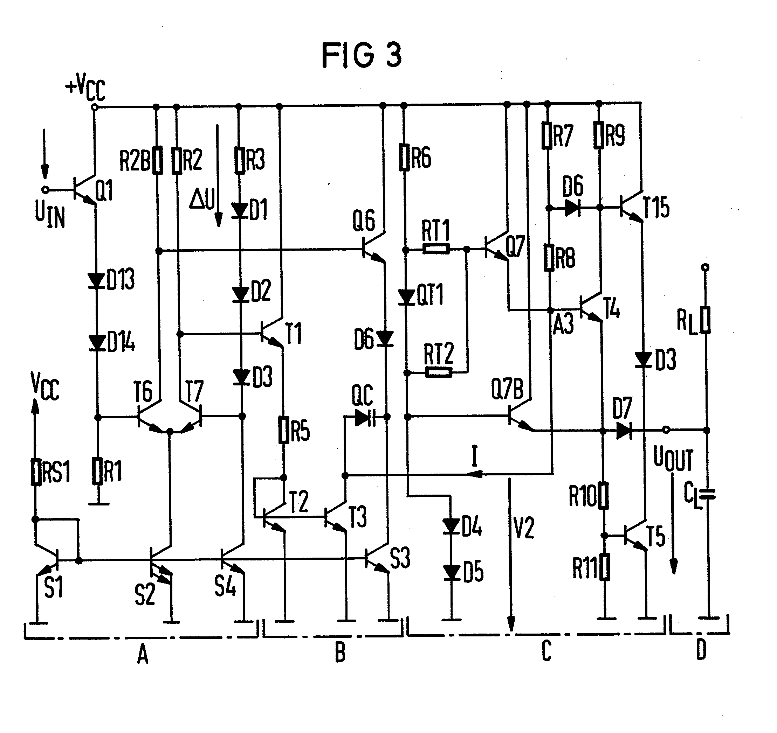

Weitere Maßnahmen zur Geschwindigkeitserhöhung sind dem Schaltbild der Fig. 3 zu entnehmen, das eine auf dem Schaltbild der Fig. 2 basierende, verbesserte Ausführungsform eines erfindungsgemäßen Pegelwandlers zeigt. Das Schaltbild nach Fig. 3 weist entsprechend der Fig. 1 die Blöcke A, B, C und D auf. Der Block A ist entsprechend der Fig. 2 mit den Transistoren T6 und T7 als Stromschalter, der Block B mit den Transistoren T1, T2 und T3 als spannungsgesteuerte Stromquelle und der Block C mit den Transistoren T4, T15 und T5 als Gegentakt-TTL-Ausgangsstufe gestaltet.

Im Vergleich zum Ausführungsbeispiel der Fig. 3 ist das Schaltverhalten des Wandlers durch Verhinderung von Sättigungseffekten bei den Transistoren T3, T4 und T5 verbessert. Zu diesem Zwecke können die Transistoren T3, T4 und T5 als Schottky-Transistoren ausgeführt werden oder entsprechend der Fig. 3 mit Klemmdioden beschaltet werden.

Der Transistor T4 wird durch die zwischen seinem Kollektor und seiner Basis geschaltete, aus der Diode T6 und dem Widerstand R8 bestehende Reihenschaltung so geklemmt, daß seine Kollektor-Emitter-Restspannung nicht soweit absinken kann, daß der Transistor T4 in gesättigtem Bereich arbeitet. Die Restspannung am Transistor wird dabei durch den Widerstand R8 bestimmt. Die Kollektor-Emitter-Restspannung des Transistors T5 wird in gleicher Weise mittels der Diode D7 und dem Widerstand R10 geklemmt.

Die Kollektor-Emitter-Restspannung des Transistors T3 wird durch den im Kollektorkreis des Transistors T3 angeordneten Transistor Q7 geklemmt, dessen Basispotential durch das Klemmnetzwerk, bestehend aus den Dioden QT1, D4, D5, den Transistoren Q7, Q7B und den Widerständen R6, RT1, RT2 auf $(k + 2) \cdot U_{be}$ festgehalten wird. k ist das Spannungsteilerverhältnis von RT1 und RT2 $(k = \frac{RT1}{RT1 + RT2})$. Das Klemmnetzwerk ist in der Weise ausgeführt, daß eine aus Widerstand R6 und den Dioden QT1, D4 und D5 bestehende Reihenschaltung vorgesehen ist, die zwischen Versorgungsspannung (Widerstand R6) und Masse (Diode D5) geschaltet ist. Vom zwischen Widerstand R6 und Diode QT1 liegenden Verbindungspunkt führt der Widerstand RT1 zur Basis des Transistors Q7, während der Widerstand RT2 vom Verbindungspunkt zwischen Diode QT1 und Diode D4 zur Basis des Transistors Q7 führt. Der Kollektor des Transistors Q7 ist mit der Versorgungsspannung $V_{cc}$ verbunden, während der Emitter des Transistors Q7 die Basis des Transistors T4 bzw. dem Punkt A3 beaufschlagt. Der Transistor Q7B ist so geschaltet, daß sein Kollektor an der Versorgungsspannung $V_{cc}$, sein Emitter am Emitter des Transistors T4 und seine Basis am Verbindungspunkt, zwischen der Diode QT1 und der Diode D4 liegen. Dadurch wird erreicht, daß das Kollektorpotential von T3 nicht unter den Wert $(k + 1)$ $U_{be}$ absinken kann.

Die Basis-Emitter-Strecken der Transistoren T4 und T5 werden mittels dieses Netzwerkes im gesperrten Zustand auf $k \cdot U_{be}$ geklemmt. Die Teilverhältnisse der beiden Spannungsteiler, gebildet aus den Widerständen R10/R11 bzw. RT1/RT2 müssen ungefähr gleich groß und vorteilhafterweise zwischen 0,5 und 0,8 gewählt werden.

Es gilt

$$k \approx \frac{R11}{R10 + R11} \approx \frac{RT2}{RT1 + RT2} \text{, mit R11 = Basis-}$$

widerstand zwischen Basis von Transistor T5 und Masse. Die Basispotentiale im leitenden Zustand ($U_{Out}$ = "Low") betragen für T4 $(\frac{1}{k} + 1) \cdot U_{be}$, für T5 $U_{be}$.

Im sperrenden Zustand begrenzt das Klemmnetzwerk das Absinken der Basispotentiale auf $(k + 1) \cdot U_{be}$ für T4 und auf $1/k \cdot U_{be}$ für T5.

Um eine zuverlässige Klemmwirkung zu erreichen, muß durch geeignete Wahl der Größen der Transistoren bzw. Dioden sichergestellt sein, daß die Basis-Emitter-Schwellspannungen der Dioden D5, D4, QT1 und die der Transistoren T4, T5, Q7 und Q7B gleich sind. Die Referenzspannung $U_{ref}$ für den aus dem Transistor T6 und T7 bestehenden Stromschalter wird in der Weise gewonnen, daß am Widerstand R3 ein Spannungsabfall erzeugt wird, der dem halben Hub des Eingangssignals $U_{IN}$ entspricht und weiter beide Spannungen (die Eingangsspannung $U_{IN}$) und die Referenzspannung $U_{ref}$ in gleicher Weise über 3 Dioden bzw. Transistorschwellen nach unten verschoben werden.

Die Stromquelle $I_n$ ist in der Weise realisiert, daß durch den Widerstand RS1 zwischen $V_{cc}$ und Basis bzw. Kollektor von S1 ein Referenzstrom definiert wird, der in bekannter Weise in den Transistor S2 gespiegelt wird. Durch die Ausstattung des Transistors S2 mit 2 Emittergebieten (Flächenfaktor = 2) wird $I_n$ den doppelten Wert des Referenzstromes $I_R = (V_{cc} - U_{be})/RS1$ annehmen.

Von besonderer Wichtigkeit ist der ECL-Hub $\Delta U$ des Ausgangsstromschalters A, der erforderlich ist, um die einwandfreie Funktion der gesamten Schaltung unter "worst-case"-Bedingungen, insbesondere Schwankungen der Versorgungsspannung $V_{cc}$ sicherzustellen. Das erforderliche Schaltpotential am Eingang A3 der TTL-Stufe C beträgt:

$$V_{2,erf} = (\frac{1}{k} + 1) \cdot U_{be} \qquad (1):$$

$$\text{mit } k = \frac{R11}{R10 + R11} = \text{Spannungsteiler-verhältnis.}$$

Das von der Stromquelle B angebotene Potential beträgt unter Vernachlässigung der Belastung durch die Diode D6 und die Transistoren T4 und Q7 (im Schaltpunkt der TTL-Stufe C gerechtfertigt) bei einem "High"-Pegel am Eingang $U_{IN}$

$$(2): \qquad V_{2,H} = V_{cc}(1 - \frac{R7 + R8}{R5}) + U_{be} \cdot \frac{R7 + R8}{R5}$$

und bei einem "Low"-Pegel am Eingang $U_{IN}$ $\qquad (3):$

$$V_{2,L} = V_{cc}[1 - \frac{R7 + R8}{R5}(1 - n\frac{R2}{RS1})] + U_{be}(2 - n\frac{R2}{RS1}) \cdot \frac{R7 + R8}{R5}$$

mit n = 2.... = Flächenfaktor des Transistors S2.

Der erforderliche Mindesthub $\Delta U_{min, erf}$ berechnet sich zu:

$$\Delta U_{min, erf} = \frac{R5}{R7 + R8}\left\{\left[\left[\left|\frac{\partial V_{2,L}}{\partial V_{cc}}\right|_{U_{be}=const} + \left|\frac{\partial V_{2,H}}{\partial V_{cc}}\right|_{U_{be}=const}\right]\cdot\Delta V_{cc} + \right.\right.$$

$$\left.\left. + \left[\left|\frac{\partial V_{2,L}}{\partial U_{be}}\right|_{V_{cc}=const} + \left|\frac{\partial V_{2,H}}{\partial U_{be}}\right|_{V_{cc}=const} - \left|\frac{d V_{2,erf}}{d U_{be}}\right|\right]\cdot\Delta U_{be}\right]\right\}$$

Durch Einsetzen von (2) und (3) erhält man:

$$\Delta U_{min, erf} = \frac{R5}{R7 + R8}\left\{\left|\left(1 - \frac{R7 + R8}{R5}\right)\left(2 - n\frac{R2}{RS1}\right)\cdot\Delta V_{cc}\right|\right.$$

$$\left. + \left[\left|\frac{R7 + R8}{R5}\left(2 - n\frac{R2}{RS1}\right)\right| - \left(1 + \frac{1}{k}\right)\right]\cdot\Delta U_{be}\right\}$$

Die Schaltung nach Fig. 3 kann z.B. unter Verwendung üblicher pn-Dioden und üblicher npn-Transistoren bezüglich der Widerstände wie folgt dimensioniert werden:

| | | | | | | |
|---|---|---|---|---|---|---|
| R2B = R2 | = | 1 | kOhm | R7 | = | 3,2 kOhm |
| R3 | = | 250 | Ohm | R8 = | 800 | Ohm |
| RS1 | = | 4,2 | kOhm | R9 | = | 1,5 kOhm |
| R1 | = | 6 | kOhm | R10= | 250 | Ohm |
| R5 | = | 2,7 | kOhm | R11= | 800 | Ohm. |
| R6 | = | 5 | kOhm | | | |
| RT1 | = | 1,6 | kOhm | | | |
| RT2 | = | 4 | kOhm | | | |

Dann beträgt der Strom der Stromquelle $I_n$ = 2mA, der ECL-Hub $\Delta U$ 2 Volt, der Strom der Stromquelle B bei "High"-Pegel 1mA und bei "Low"-Pegel 0,4 mA. Die Koppelkapazität QC beträgt 2 pF, die Versorgungsspannung $V_{cc}$ ÷ 5 Volt.

Geht man bei Gleichung (5) von maximalen Schwankungen der Versorgungsspannung $V_{cc}$ von üblicherweise $\Delta V_{cc}$ = 1 Volt und von temperaturbedingten Schwankungen $\Delta U_{be}$ der Basis-Emitter-Schwellspannungen $U_{be}$ $\Delta U_{be}$ = 0,25 Volt aus, so ergibt sich bei der genannten Dimensionierung:

$$\Delta U_{min,\ erf} = 0,45 \text{ Volt.}$$

Der in der Schaltung verwendete Hub $\Delta U$ von 2 Volt gewährleistet daher die Einhaltung eines ausreichenden Störabstandes unter "worst-case"-Bedingungen. Um gleichen Störabstand nach beiden Richtungen zu erhalten, muß der Schaltpunkt der TTL-Stufe C bei $\Delta U/2$ erreicht werden.
Hierfür gilt die Bedingung:

$$\frac{R7 + R8}{R5} = \frac{V_{cc} - (\frac{1}{K} + 1)\cdot U_{be}}{V_{cc}(1 - \frac{n}{2}\frac{R2}{RS1}) - U_{be}(2 - \frac{n}{2}\frac{R2}{RS1})}$$

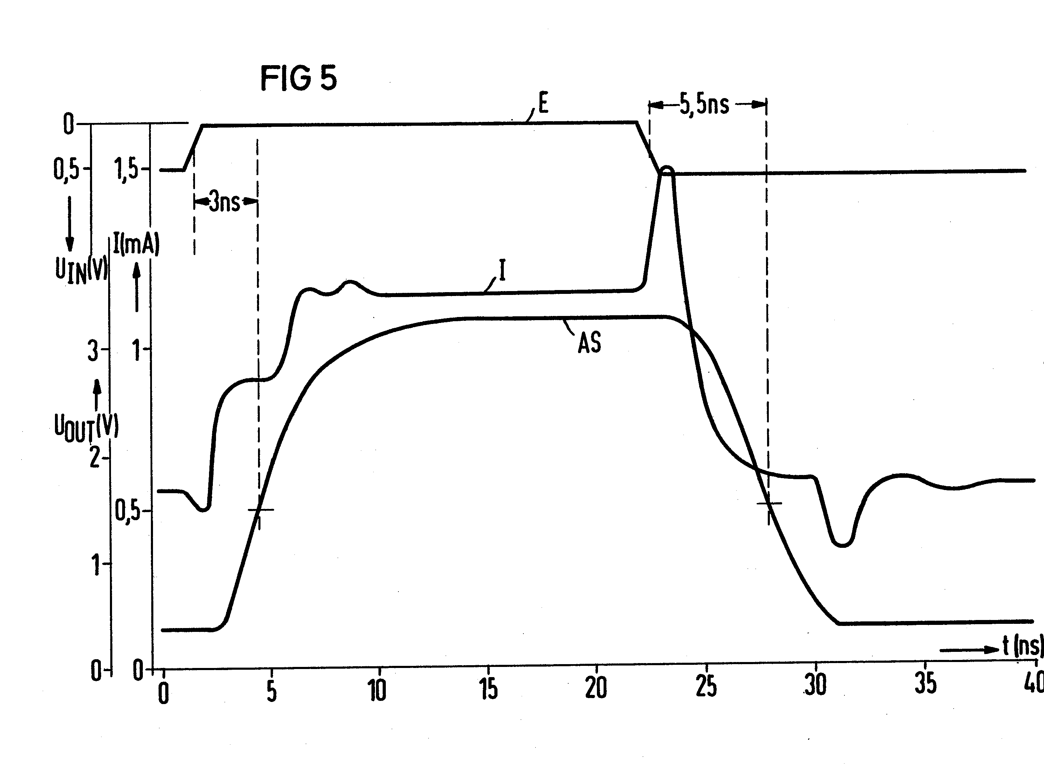

Das Schaltverhalten eines Wandlers nach Fig. 3, der wie oben ausgeführt, dimensioniert ist, zeigt die Fig. 5, wobei alle Transistoren im $f_T$-Optimum betrieben werden, d.h. die Größe ihrer BE-Dioden wurde so auf die zu schaltenden Kollektorströme abgestimmt, daß die Transistor-Schaltzeiten minimiert werden.

Wie dem zeitlichen Verlauf des am Eingang $U_{IN}$ anliegende ECL-Eingangsimpulses E und dem zeitlichen Verlauf des am Ausgang $U_{Out}$ anliegenden TTL-Ausgangsimpulses AS zu entnehmen ist, liegen die Schaltzeiten für steigende und fallende Flanke unter 6 ns.

Wie Tabelle 1 zu entnehmen ist, weist diese Schaltung einen sehr konstanten "Low"-Ausgangspegel in allen "worst-case"-Fällen auf ($V_{OL}$ (V) = Ausgangs-Low-Pegel in Abhängigkeit von Versorgungsspannung und Temperatur).

Tab. 1

| $V_{OL}$(v) | 0 °C | 27 °C | 70 °C |
|---|---|---|---|
| 4,5 V | 0,373 | 0,367 | 0,358 |
| $V_{cc}$ 5 V | 0,369 | 0,363 | 0,356 |
| 5,5 V | 0,367 | 0,361 | 0,357 |

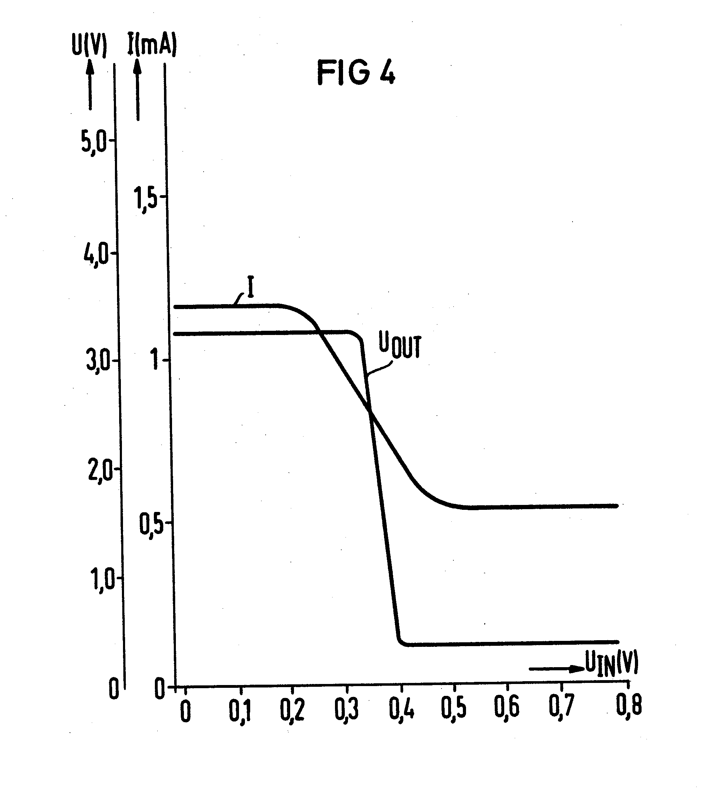

Die statische Übertragungskennlinien der Schaltung nach Fig. 3 sind der Fig. 4 zu entnehmen, die den Steuerstrom I und die am Ausgang $U_{Out}$ anliegende TTL-Ausgangsspannung in Abhängigkeit von Eingangsspannung $U_{IN}$ zeigt.

5 Figuren

8 Patentansprüche

0094044

Patentansprüche

1. Schaltungsanordnung zur Pegelumsetzung von ECL-Logik-Pegeln zu TTL-Logik-Pegeln mit einem eingangsseitig von ECL-Logik-Pegeln beaufschlagten emittergekoppelten Stromschalter und einer TTL-Ausgangsstufe,
   d a d u r c h   g e k e n n z e i c h n e t ,
   daß eine spannungsgesteuerte Stromquelle (B) vorgesehen ist, die eingangsseitig von einem Ausgang des Stromschalters (A) beaufschlagt ist und die ausgangsseitig mit der TTL-Ausgangsstufe (C) verbunden ist.

2. Schaltungsanordnung nach Anspruch 1,
   d a d u r c h   g e k e n n z e i c h n e t ,
   daß die Stromquelle (B) als Stromspiegel mit Transistordiode (T2) ausgeführt ist.

3. Schaltungsanordnung nach Anspruch 1 oder 2,
   d a d u r c h   g e k e n n z e i c h n e t ,
   daß die Stromquelle (B) eingangsseitig vom nicht invertierenden Ausgang des Stromschalters (A) beaufschlagt ist.

4. Schaltungsanordnung nach einem der Ansprüche 1 bis 3,
   d a d u r c h   g e k e n n z e i c h n e t ,
   daß zwischen dem invertierenden Ausgang des Stromschalters (A) und dem Eingang (A3) der TTL-Ausgangsstufe (C) eine Kapazität (QC) geschaltet ist.

5. Schaltungsanordnung nach einem der Ansprüche 1 bis 4,

d a d u r c h   g e k e n n z e i c h n e t ,

daß die TTL-Ausgangsstufe (C) als Gegentaktstufe (T5, T15) ausgeführt ist.

6. Schaltungsanordnung nach einem der Ansprüche 1 bis 5,

d a d u r c h   g e k e n n z e i c h n e t ,

daß Anordnungen (D6, R8, D7, R10) zum Klemmen der Kollektor-Emitter-Restspannung mindestens eines Transistors der TTL-Ausgangsstufe (C) vorgesehen sind.

7. Schaltungsanordnung nach einem der Ansprüche 1 bis 6,

d a d u r c h   g e k e n n z e i c h n e t ,

daß Anordnungen (R6, QT1, D4, D5, Q7, Q7B) zum Klemmen der Basispotentiale mindestens eines Transistors der TTL-Ausgangsstufe (C) vorgesehen sind.

8. Schaltungsanordnung nach einem der Ansprüche 1 bis 7,

d a d u r c h   g e k e n n z e i c h n e t ,

daß eine Anordnung (Q7) zum Klemmen der Kollektor-Emitter-Restspannung des Arbeitstransistors (T3) des Stromspiegels (B) vorgesehen ist.

## FIG 1

## FIG 2

# FIG 3

FIG 4

FIG 5